# EUROPEAN PATENT SPECIFICATION

(11) **EP 3 154 325 B1**
(45) Date of publication and mention of the grant of the patent: **24.10.2018**
(21) Application number: 14893958.0
(22) Date of filing: 03.06.2014
(51) Int. Cl.: H05K 13/02, H05K 13/04

(54) **COMPONENT SUPPLY DEVICE AND SURFACE MOUNTER**
KOMPONENTENZUFUHRVORRICHTUNG UND OBERFLÄCHENMONTAGEVORRICHTUNG
DISPOSITIF DE DISTRIBUTION DE COMPOSANTS ET MONTEUR EN SURFACE

(43) Date of publication of application: 12.04.2017
(73) Proprietor: Yamaha Hatsudoki Kabushiki Kaisha, Iwata-shi, Shizuoka 438-8501 (JP)
(72) Inventor: KURAYAMA, Tomoharu, Iwata-shi Shizuoka 438-0026 (JP)
(74) Representative: Müller-Boré & Partner Patentanwälte PartG mbB
(86) International application number: PCT/JP2014/064762
(87) International publication number: WO 2015/186196

(56) References cited:
- JP-A- 2006 319 299
- JP-A- 2009 245 997
- JP-A- 2009 245 997
- JP-A- 2010 103 273
- US-A- 5 213 653

## Description

### TECHNICAL FIELD

The present invention relates to technology of preventing entangling of a top tape.

### BACKGROUND ART

A tape feeder has been known as an example of devices that supply electronic components to a surface mounting device. A tape feeder draws a component supply tape that includes electronic components at a certain interval thereon and feeds the tape to a pickup position that is at a front position in the feeder. The electronic components are picked up from the tape by a mount head in the pickup position. The component supply tape includes a career tape having component storing portions and a top tape. The tape feeder includes a drawing device that draws the top tape and separates the top tape from the career tape during feeding of the tape. Patent Document 1 describes that the roller-type drawing device includes a pawl member on the roller and the top tape is separated from roller teeth.

### RELATED ART

### [Patent Document 1]

Japanese Unexamined Patent Publication No. 2003-188582 (Problems to be Solved)

As electronic components have been reduced in size, a component supply tape also tends to be reduced in size. A minimum tape has a small tape width and tensility is low. Therefore, the top tape is less likely to be fed smoothly and the top tape may be accumulated in a downstream position from the roller where conveyance of tape is interrupted. In such a position, the accumulated top tape may be entangled with the roller.

US 5 213 653 A discloses a tape feed and dispensing mechanism for feeding a tape containing a carrier strip carrying articles to be dispensed and a protective covering for covering the carrier strip and retaining the articles upon it.

JP 2009 245997 A discloses a component supply device. A winding prevention member is secured to a body frame of a component supply device.

JP 2010 103273 A discloses a component supply device. The component supply device is provided with a taking-over part for conveying a component supply tape.

### DISCLOSURE OF THE INVENTION

The technology disclosed herein was made in view of the above circumstances. An object is to restrain entangling of a top tape.

### Means for Solving the Problem

A component supplying device according to the present invention is defined in claim 1. A component supply minimum tape has a tape width of 8 mm or less.

### Effects of the Invention

According to the present invention, entangling of a top tape is less likely to occur.

### BRIEF DESCRIPTION OF THE DRAWINGS

FIG. 1 is a plan view illustrating a surface mounting device according to one embodiment.
FIG. 2 is a view illustrating a support structure of a head unit.
FIG. 3 is a perspective view illustrating a component supply tape.
FIG. 4 is a front view illustrating a feeder.
FIG. 5 is a perspective view illustrating the feeder.
FIG. 6 is a view illustrating a part of the feeder in FIG. 4.
FIG. 7 is a perspective view illustrating a lever.
FIG. 8 is a front view illustrating the lever.
FIG. 9 is a bottom view illustrating the lever.
FIG. 10 is a view illustrating a part of the feeder in FIG. 4.
FIG. 11 is a view illustrating a part of the feeder in FIG. 5.
FIG. 12 is a view illustrating a part of the feeder in FIG. 5.
FIG. 13 is a view illustrating the vicinity of a pinch roller and a drawing roller according to another embodiment.
FIG. 14 is a perspective view illustrating a lever according to another embodiment.

### EXPLANATION OF SYMBOLS

1: surface mounting device
11: base mount
30: driving device
60: head unit
63: mount head
70: component supply tape
71: carrier tape
75: top tape
80: feeder (example of a component supplying device according to the present invention)
90: feeding device
100: drawing device
110: tension roller (example of a pair of rollers according to the present invention)
121: first member
125A, 125B: second member
130: pinch roller (example of a pair of rollers according to the present invention)
151: first member
155A, 155B: second member
200: tape storing portion
L1: outline

### BEST MODES FOR CARRYING OUT THE INVENTION

### <One Embodiment>

### 1. Whole Structure of Surface Mounting Device

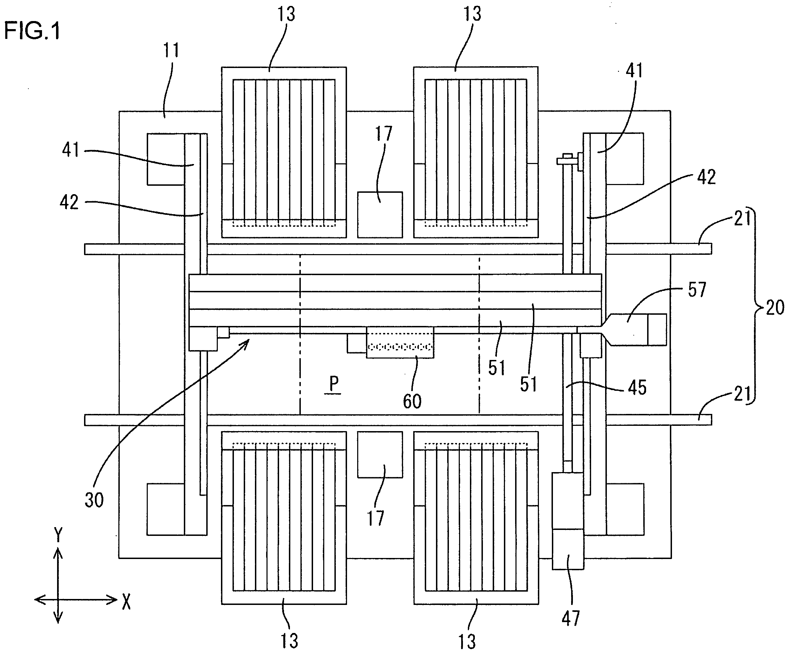

As illustrated in FIG. 1, a surface mounting device 1 includes a base mount 11, a transfer conveyer 20 that conveys a printed board P, a head unit 60, and a driving device 30 that moves the head unit 60 on the base mount 11 along a plan surface (in a X direction and a Y direction). A longitudinal direction of the base mount 11 (a left-right direction in FIG. 1) corresponds with the X direction and a depth direction of the base mount 11 (an up-down direction in FIG. 1) corresponds with a Z direction.

The transfer conveyer 20 is arranged in a middle of the base mount 11. The transfer conveyer 20 includes a pair of transfer belts 21 that is moved in circulation in the X direction. The transfer conveyer 20 conveys a printed board P on the transfer belt 21 in the X direction by friction caused between the belt and the printed board P.

In this embodiment, a carry-in port is on a left side in FIG. 1 and the printed board P is conveyed into the device via the transfer conveyer 20 from the left side in FIG. 1. The printed board P in the device is conveyed to a working position that is in a middle of the base mount via the transfer conveyer 20 and stopped there.

Four component supply sections 13 are located on the base mount 11 to surround the working position. Each of the component supply sections 13 includes feeders 15 that are arranged laterally and supply electronic components.

In the working position, the electronic component supplied via the feeder 15 is mounted on the printed board P by a mount head 63 mounted in the head unit 60. After the mounting process, the printed board P is conveyed by the conveyer 20 rightward in FIG. 1 and discharged outside the device.

The driving device 30 includes a pair of support legs 41, a head support body 51, a Y-axis ball screw 45, a Y-axis motor 47, a X-axis ball screw 55, and a X-axis motor 57. Specifically, as illustrated in FIG. 1, a pair of support legs 41 is arranged on the base mount 11. The support legs 41 are arranged on two sides of the working position, respectively, and extend straight in the Y direction.

A guide rail 42 extending in the Y direction is arranged on each of the support legs 41 and the head support body 51 is mounted on the right and left guide rails 42 such that end portions of the head support body 51 with respect to the longitudinal direction are mounted on the respective guide rails 42.

The Y-axis ball screw 45 extending in the Y direction is mounted on the right-side support leg 41 and a ball nut (not illustrated) is screwed to the Y-axis ball screw 45. The Y-axis motor 47 is connected to the Y-axis ball screw 45.

As the Y-axis motor 47 is energized, the ball nut is moved forward or backward along the Y-axis ball screw 45. Accordingly, the head support body 51 that is fixed to the ball nut and the head unit 60, which will be described later, is moved in the Y direction along the guide rail 42 (Y-axis servo mechanism) .

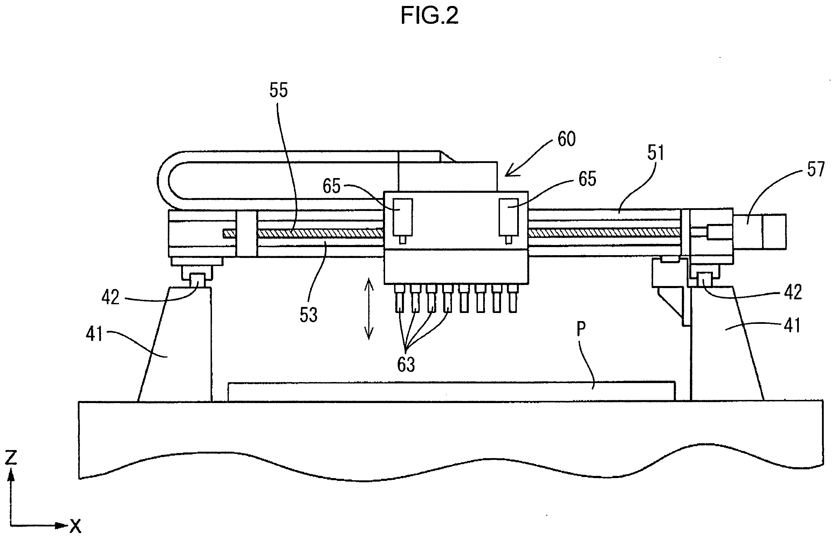

The head support body 51 has an elongated shape extending in the X direction. As illustrated in FIG. 2, a guide member 53 extending in the X direction is arranged on the head support body 51 and the head unit 60 is mounted on the guide member 53 so as to be movable along an axis of the guide member 53. The head support body 51 includes the X-axis ball screw 55 extending in the X direction and a ball nut is screwed to the X-axis ball screw 55.

The X-axis motor 57 is connected to the X-axis ball screw 55 and as the motor 57 is energized, the ball nut is moved forward or backward along the X-axis ball screw 55. Accordingly, the head unit 60 that is fixed to the ball nut is moved in the X direction along the guide member 53 (X-axis servo mechanism).

Therefore, the head unit 60 can be controlled to be moved in a planar direction (X direction and Y direction) on the base mount 11.

The head unit 60 includes mount heads 63 that execute operation of mounting electronic components. Each of the mount heads 63 is moved up and down with respect to the head unit 60 by axial rotation of an R-axis motor and a driving of the Z-axis motor. Each mount head 63 is configured such that a negative pressure is supplied thereto from negative pressure application means (not illustrated) and to generate suction force at a distal end of the head.

With such a configuration, by operating the X-axis motor 57, the Y-axis motor 47, and the Z-axis motor at a certain timing, an electronic component is supplied via the feeder 15 and the mount head 63 picks up the electronic component and mount the electronic component on the printed board P.

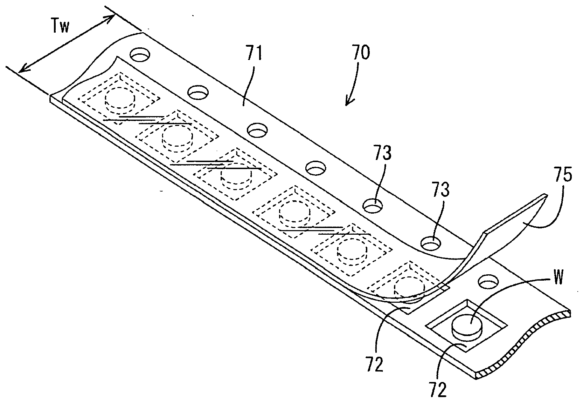

A number "17" in FIG. 1 represents a component check camera and a number "65" in FIG. 3 represents a board check camera. The component check camera 17 is fixed to the base mount 11 such that an imaging face thereof faces upward. The component check camera 17 takes images (lower surface images) of the electronic components that are picked up by the mount head 63 for detecting a suctioned posture of the electronic component suctioned by the mount head 63. The board check camera 65 is fixed to the head unit 60 such that an imaging face thereof faces downward and movable together with the head unit 60. Accordingly, an image of a desired portion of the printed board P is taken by the board check camera 65 by activating the X-axis servo mechanism and the Y-axis servo mechanism.

2. Configurations of Component Supply Tape 70 and Feeder 80

As illustrated in FIG. 3, the component supply tape 70 includes a career tape 71 and a top tape 75 that is adhered to the career tape 71. A material of the career tape 71 may be synthetic resin and a material of the top tape 75 may be synthetic resin. The career tape 71 includes component storing portions 72 having a space therein and open upwardly and the component storing portions 72 are arranged at a certain interval. A small-sized electronic component such as a chip resistor is arranged in each of the component storing portions 72. The career tape 71 has fitting holes 73 on one edge side along an edge thereof at a certain interval. The component supply tape 70 is wound up around a reel (not illustrated) in a rear portion of a feeder 80.

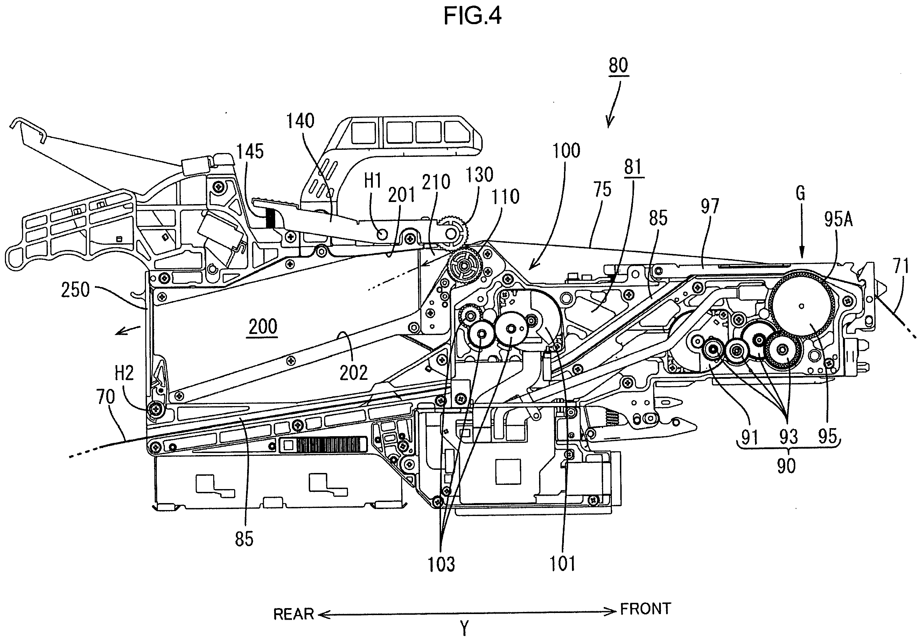

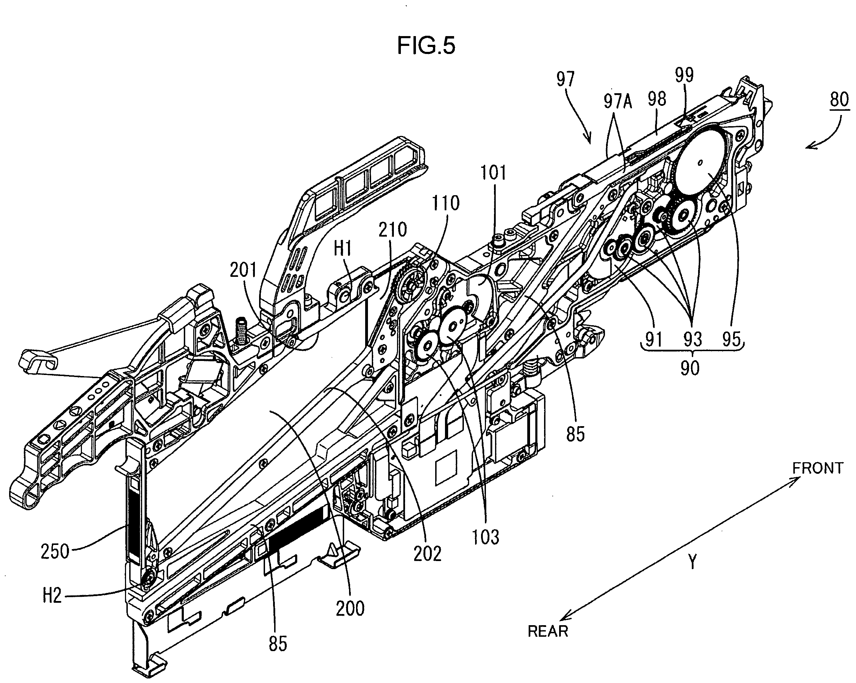

As illustrated in FIGS. 4 and 5, the feeder (an example of a component supplying device of the present invention) 80 includes a feeding device 90, a tape guide 97, a drawing device 100, a tape storing portion 200, and a frame 81 where the components are mounted. The frame 81 extends in the Y direction and is made with aluminum die casting, for example. The frame 81 includes a tape passage 85 through which the component supply tape 70 passes. The tape passage 85 extends from a rear edge of a lower portion of the frame 81 toward a front side. Then, the tape passage 85 extends toward an oblique upper side and is continuous to an upper surface of the frame 81.

The feeding device 90 is mounted in a front portion of the frame 81. The feeding device 90 includes a first motor 91, a gear train 93 including gears, and a sprocket 95. The gear train 93 transmits power from the first motor 91 to the sprocket 95 and rotates the sprocket 95. The sprocket 95 is arranged in a front end upper portion of the frame 81. The sprocket 95 has teeth 95A at an equal interval on an outer periphery thereof. The teeth 95A of the sprocket 95 are fit in the fitting holes 73 of the component supply tape 70. As the sprocket 95 is rotated, the component supply tape 70 is fed to the component pick-up position G that is in a front portion of the feeder.

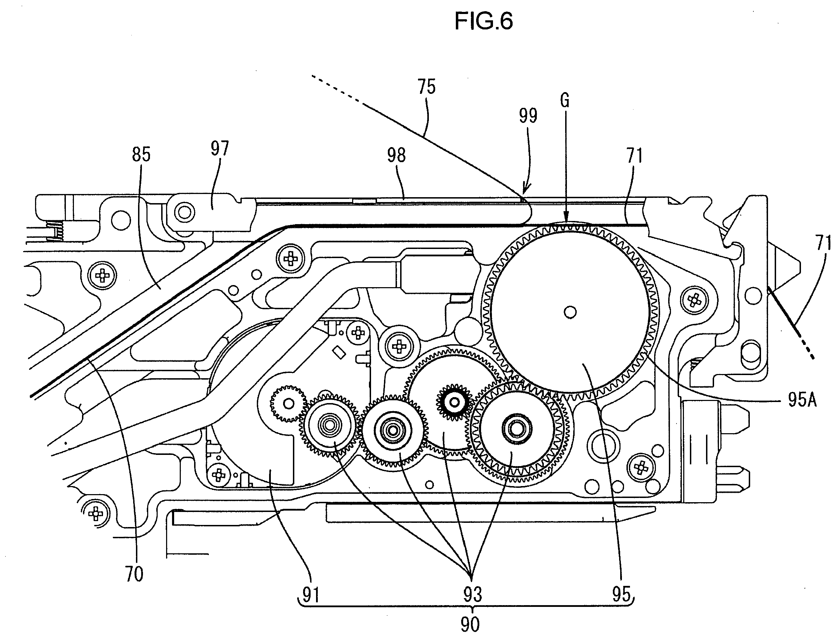

The tape guide 97 has an elongated shape extending in a front-rear direction and mounted on an upper surface of a front portion of the frame 81. The tape guide 97 includes guide walls 97A that guide two sides of the component supply tape 70 such that a posture of the component supply tape 70 that is conveyed on the frame is less likely to be inclined. As illustrated in FIG. 5, the tape guide 97 has a slit 99 in an upper surface 98 and the top tape 75 is folded rearward via the slit 99. As illustrated in FIG. 6, the slit 99 is formed on a rear side with respect to the component pick-up position G. When the top tape 75 passes by just below the slit 99, the top tape 75 is folded rearward and separated from the carrier tape 71.

The career tape 71 is conveyed as a single unit to the component pick-up position G after the top tape 75 is separated therefrom. Accordingly, the electronic components W are convened together with the career tape 71 to the component pick-up position G. At the same timing, the mount head 63 is moved to the component pick-up position G so that the mount head 63 can pick up the electronic component W from the component storing portion 72 of the career tape 71.

The drawing device 100 includes a second motor 101, a gear train 103 including gears, a tension roller 110, and a pinch roller 130. The tension roller 110 and the pinch roller 130 correspond with "a pair of rollers" of the present invention. The gear train 103 transfers power from the second droller 101 to the tension roller 110 and rotate the tension roller 110. The tension roller 110 and the pinch roller 103 are opposite each other in an introduction portion 210 of the tape storing portion 200. The tension roller 110 and the pinch roller 130 have drawing teeth 115, 135, respectively, on an outer peripheral portion thereof. The catching teeth 115, 135 are used for drawing the top tape 75 and are engaged with each other.

The pinch roller 130 is fixed to a lever 140 that is swingable around a hinge H1 and the lever 140 is operated such that the pinch roller 130 is in contact with the tension roller 110 or is away from the tension roller 110.

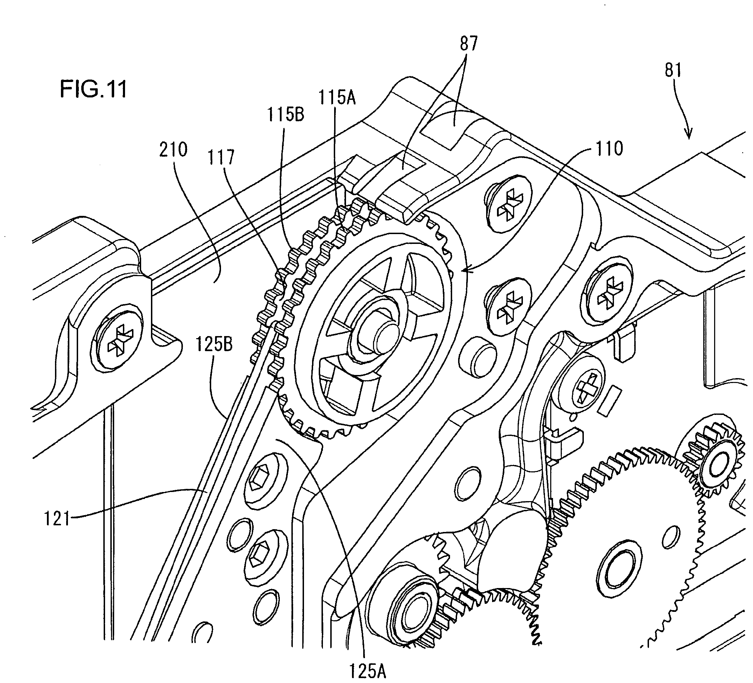

The lever 140 includes a spring that urges the pinch roller 130 downwardly. With such a configuration, the top tape 75 that is directed rearward via the slit 99 is held by the two rollers 110, 130 and when the tension roller 110 is rotated, the top tape 75 is drawn rearward by the two rotating rollers 110, 130. Thus, the top tape 75 is stored in the tape storing portion 200. As illustrated in FIG. 11, the frame 81 includes a tape guide recess 87 on an upper portion of a wall surface thereof that surrounds a front portion of the tension roller 110. The tape guide recess 87 is configured to restrict a position of the top tape 75 such that the top tape 75 is not shifted laterally with respect to the tension roller 110 and the pinch roller 130.

The tape storing portion 200 is disposed on a rear side with respect to the frame 81 and includes an introduction portion 210 in an upper front end portion. The top tape 75 is introduced via the introduction portion 210. The tension roller 110 and the pinch roller 130 are arranged in the introduction portion 210. The tape storing portion 200 stores the top tape 75 that is separated from the carrier tape 71. The tape storing portion 200 includes a cover 250 on a rear surface side thereof. The cover 250 can be opened and closed. If the cover 250 is open, the tape storing portion 200 is open at the rear portion thereof. The top tape 75 stored therein can be taken out through the rear portion of the tape storing portion 200.

### 3. Top Tape 75 Entangling Prevention Measure

Recently, as electronic components have been reduced in size, the component supply tape 70 tends to be minimized in size. A minimum tape having a tape width (Tw in FIG. 3) of 8 mm or less has low tensility and the top tape 75 is less likely to be conveyed smoothly. Therefore, if conveyance of the tape is stopped in a rear area with respect to the tension roller 110 and the pinch roller 130, the top tape 75 is retained there and the retained top tape 75 may be entangled with the tension roller 110 and the pinch roller 130. The feeder 80 supplying electronic components with using a minimum tape prevents such entangling of the top tape as follows.

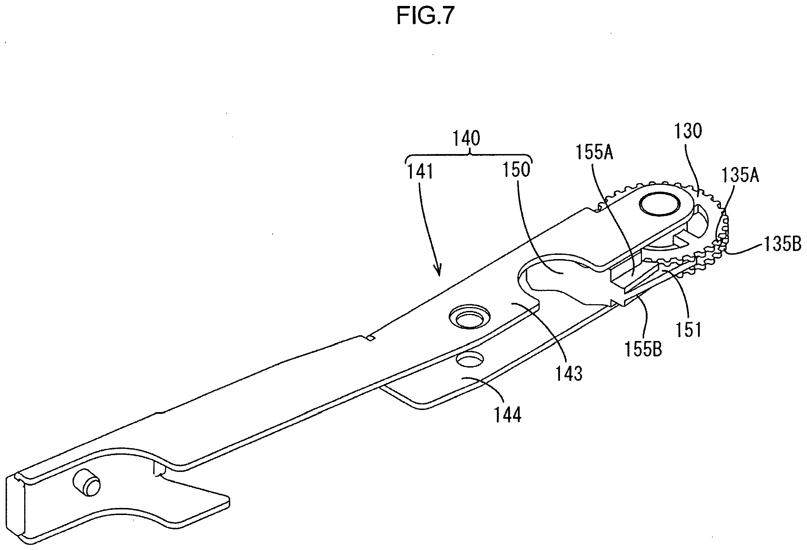

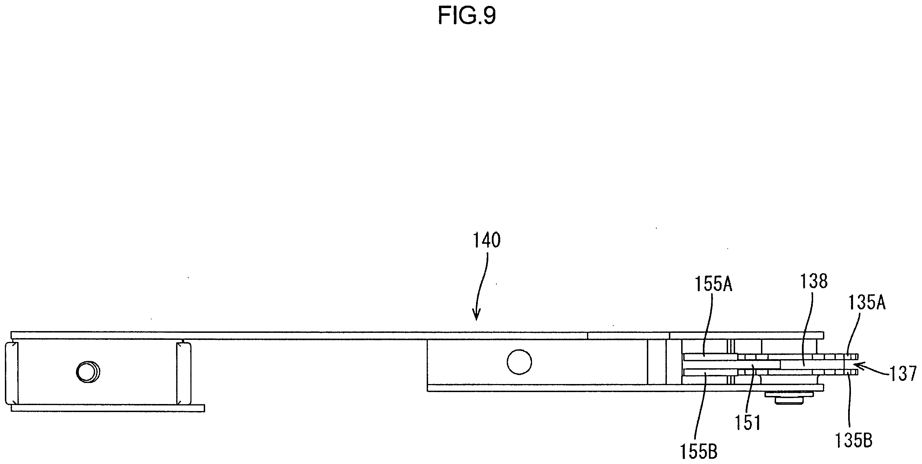

As illustrated in FIG. 7, the drawing teeth 135 of the pinch roller 130 has a double teeth-member structure. The pinch roller 130 includes two teeth-members that have drawing teeth 135A, 135B on an outer peripheral portion thereof, respectively. The drawing teeth 135A and the drawing teeth 135B are away from each other at a certain distance. As illustrated in FIG. 9, a groove portion 137 is formed between the two drawing teeth 135A, 135B.

As illustrated in FIG. 7, the lever 140 includes a lever main body 141 and a roller guide 150. The lever main body 141 includes a pair of opposed side walls 143, 144 and holds the pinch roller 130 to be rotatable.

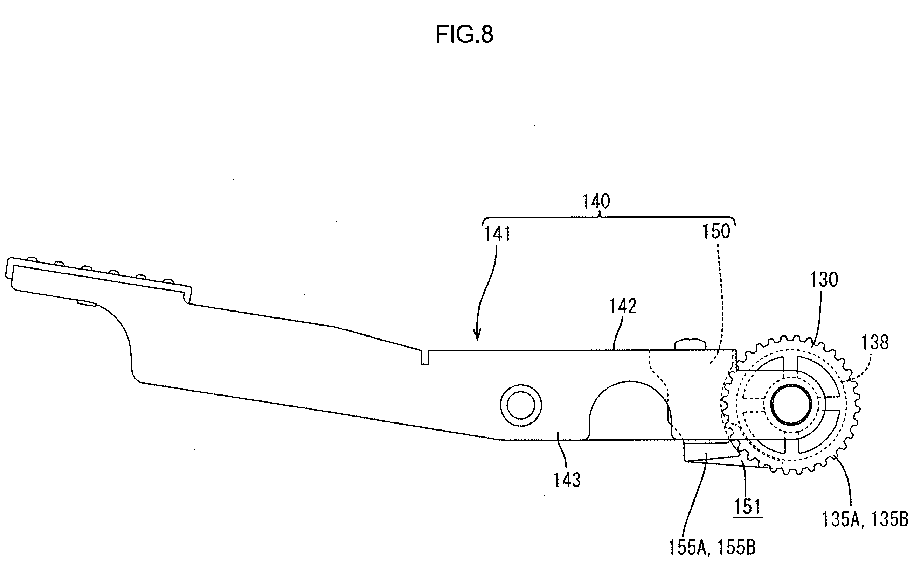

The roller guide 150 is arranged between the side walls 143, 144 of the lever main body 141. As illustrated in FIG. 8, the roller guide 150 is fixed to a ceiling wall 142 of the lever main body 141 via a screw from an outer side. The roller guide 150 is arranged on a rear side with respect to the pinch roller 130 and includes a first member 151 and second members 155.

As illustrated in FIG. 9, the first member 151 is located corresponding with the groove portion 137 with respect to an axial direction (an up-down direction in FIG. 9) of the roller. The first member 151 is fit in the groove portion 137 of the pinch roller 130 from the rear side.

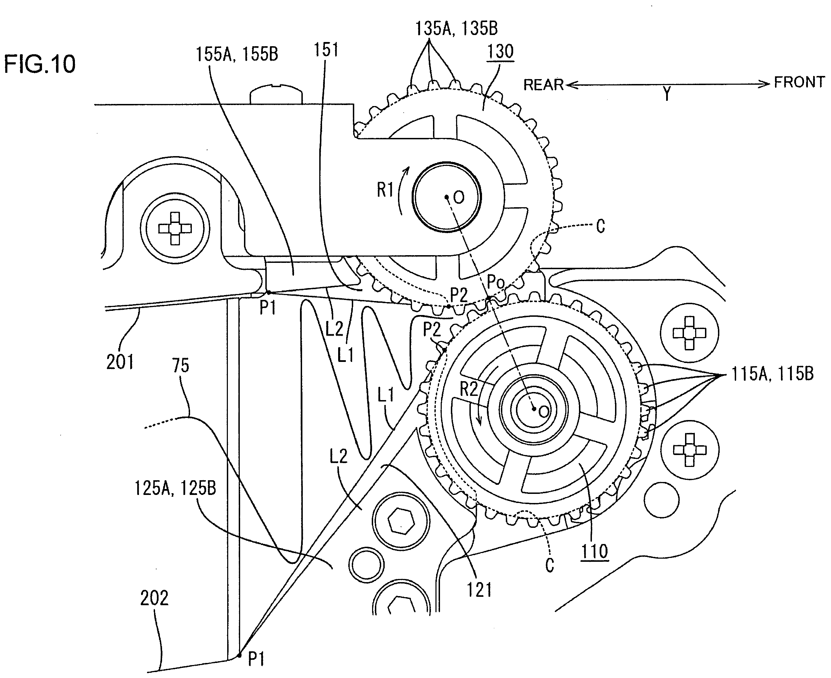

As illustrated in FIG. 8, the first member 151 has an arched shape such that a distal end portion of the first member 151 overlaps a recessed portion (a groove bottom portion) 138 of the pinch roller 130 on an outer side and surrounds a lower rear portion of the recessed portion 138. As illustrated in FIG. 10, the first member 151 overlaps the drawing teeth 135A, 135B at a forward position from an engaging point Po (a point where the two drawing teeth 115 and 135 are engaged) with respect to a rotating direction of the pinch roller 130. The first member 151 is configured to release the top tape 75 from the drawing teeth 135A, 135B. In FIG. 10, center of each of the pinch roller 130 and the tension roller 110 is represented by "O".

In relation to the drawing teeth 135A, 135B of the pinch roller 130, the first member 151 has a tangent to a root circle C of the drawing teeth 135. Namely, an outline L1 of the first member 151 (a portion where the top tape 75 is released from the drawing teeth 135A, 135B) is a tangent (a straight line) to the root circle C.

The outline L1 of the first member 151 is a tangent to the root circle C. With such a configuration, as illustrated in FIG. 10, the top tape 75 released from the drawing teeth 135A, 135B of the pinch roller 130 is conveyed along the outline L1 of the first member 151. Therefore, the conveyance of the tape is not interrupted in the rear area with respect to the pinch roller 130 and the top tape 75 is not retained in the rear area with respect to the pinch roller 130. Accordingly, the entangling of the top tape 75 with the pinch roller 130 is less likely to occur. The outline L1 of the first member 151 is a tangent to the root circle C. Such a configuration provides following advantages compared to a configuration that the outline of the first member 151 is a tangent to an addendum circle. If the outline is a tangent to the addendum circle, the distal end portion of the first member 151 overlaps the tooth tips of the drawing teeth 135. With such a configuration, the top tape 75 caught by the drawing teeth 135 may be in contact with the distal end portion of the first member 151 and may be entangled with the pinch roller 130. With the first member 151 having the outline L1 that is a tangent to the root circle C, the distal end portion of the first member 151 is not overlapped with the drawing teeth 135 and is inner side. Therefore, the top tape 75 is not in contact with the distal end portion of the first member 151 and may not be entangled with the pinch roller 130.

The outline L1 of the first member 151 is a straight line connecting a point P1 in FIG. 10 and a point P2 on the root circle C. In relation to the engagement point Po, the outline L1 is in contact with the root circle C on a rear side (on a left side in FIG. 10) with respect to the engagement point Po. The point P1 is arbitrarily determined according to a shape of the tape storing portion 200. In the present embodiment, the point P1 is at a front end portion of a vertical wall 201 such that the outline L1 of the first member 151 is continuous to the vertical wall 201 that is on upper side with respect to the tape storing portion 200.

Second members 155A, 155B are formed on both sides of the first member 151, respectively. As illustrated in FIG. 9, the second members 155A, 155B are located corresponding with the drawing teeth 135A, 135B, respectively, with respect to the axial direction of the roller (the up-down direction in FIG. 9).

As illustrated in FIG. 8, the second members 155A, 155B have distal end portions having an arched shape that overlaps the drawing teeth 135A, 135B of the pinch roller 130 on an outer side. The distal end portions of the second members 155A, 155B surround the drawing teeth 135A, 135B from the rear side. As illustrated in FIG. 10, each of the second members 155A, 155B has an outline L2 that is inclined upwardly in FIG. 10 with respect to the outline L1 of the first member 151. A step is formed between the first member 151 and each of the second members 155A, 155B.

The second members 155A, 155B are located at a forward position from the first member 151 with respect to the rotating direction (a direction R1 in FIG. 10) of the pinch roller 130. Therefore, even if the top tape 75 is separated from the first member 151, the separated tape 75 is less likely to be entangled with the pinch roller 130.

As illustrated in FIG. 11, the tension roller 110 has a double teeth-member structure like the pinch roller 130. The tension roller 110 includes two teeth-members having drawing teeth 115A, 115B, respectively, on outer peripheral surfaces. Each of the drawing teeth 115A, 115B of the tension roller 110 is engaged with each of the drawing teeth 135A, 135B of the pinch roller 130. Similarly to the pinch roller 130, the entangling prevention measure is also applied to the tension roller 110.

A first member 121 and second members 125A, 125B are arranged on a rear side with respect to the pinch roller 130. The first member 121 is integrally formed with the second members 125A, 125B and fixed to the frame 81. As illustrated in FIG. 10, the first member 121 is fit in a groove portion 117 of the tension roller 110 from the rear side. The first member 121 has an outline L1 (a portion where the top tape 75 is released from the drawing teeth 115A, 115B) that is a tangent to a root circle C of the drawing teeth 115A, 115B of the tension roller 110.

With the configuration that the outline L1 of the first member 121 is a tangent to the root circle C, as illustrated in FIG. 10, the top tape 75 released from the drawing teeth 115A, 115B of the tension roller 110 is conveyed along the outline L1 of the first member 121. Therefore, the conveyance of the tape is not interrupted on a rear area with respect to the tension roller 110 and the top tape 75 is not retained in the rear area with respect to the tension roller 110. The entangling of the top tape 75 with the tension roller 110 is less likely to occur.

The outline L1 of the second member 121 is a straight line connecting a point P1 in FIG. 10 and a point P2 on the root circle C. The outline L1 is in contact with the root circle C on a rear side (on a left side in FIG. 10) with respect to the engagement point Po. The point P1 is arbitrarily determined according to a shape of the tape storing portion 200. In the present embodiment, the point P1 is at a front end portion of a vertical wall 202 such that the outline L1 of the first member 151 is continuous to the vertical wall 202 that is on a lower side with respect to the tape storing portion 200.

Each of the second members 125A, 125B has an outline L2 that is inclined downwardly in FIG. 10 with respect to the outline L1 of the first member 121. A step is formed between the first member 121 and each of the second members 125A, 125B. The second members 125A, 125B are at a forward position from the first member 121 with respect to a rotating direction (a direction R2 in FIG. 10).

Even if the top tape 75 is shifted and deviated from the first member 121, the separated tape 75 is less likely to be entangled with the tension roller 110.

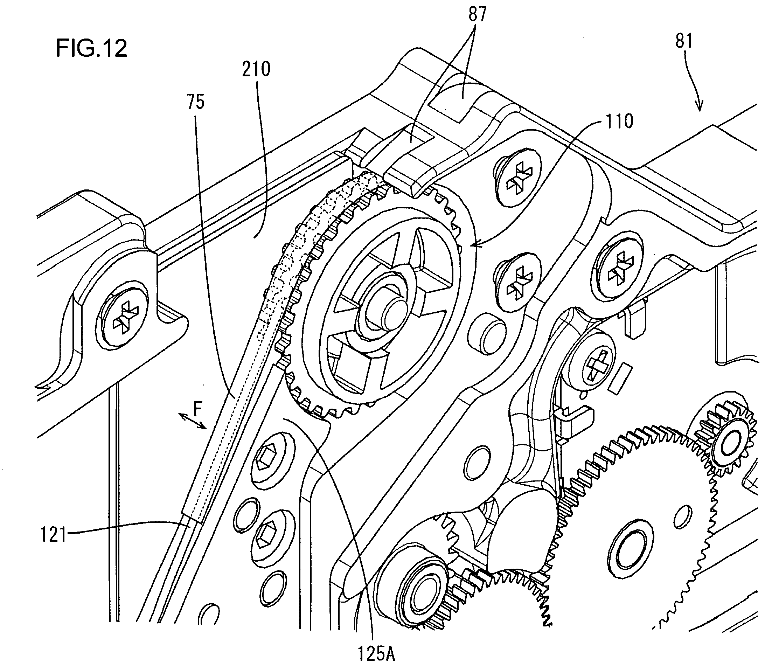

In the feeder 80, each of the tension roller 110 and the pinch roller 130 has a double teeth-member structure and each of the first members 121, 151 is fit in a space between the two teeth-members of each of the tension roller 110 and the pinch roller 130. Accordingly, even if the top tape 75 is shifted and deviated laterally (the tape is shifted in a direction F in the drawing), a part of the top tape 75 overlaps the first member 121, 151, as illustrated in FIG. 12. Thus, the top tape 75 is less likely to be separated from the drawing teeth 115A, 115B of the tension roller 110 and the drawing teeth 135A, 135B of the pinch roller 130.

### <Other Embodiments>

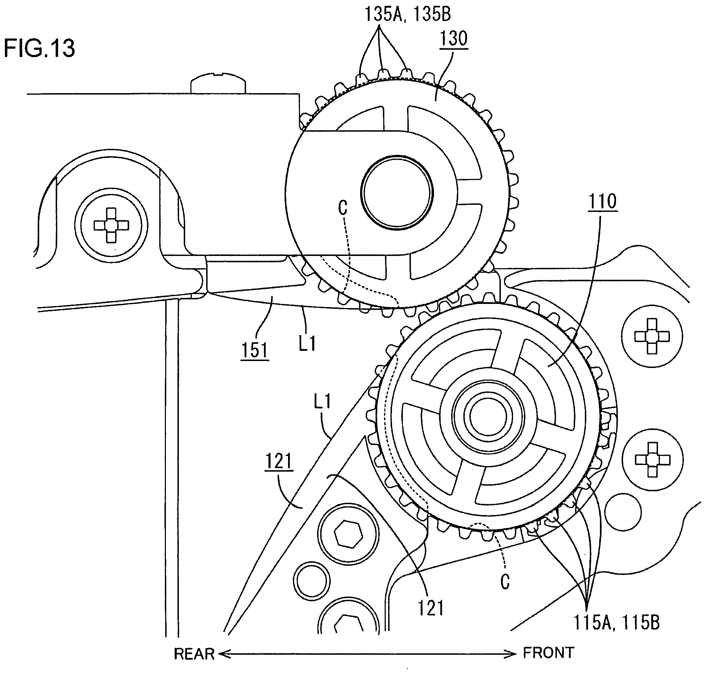

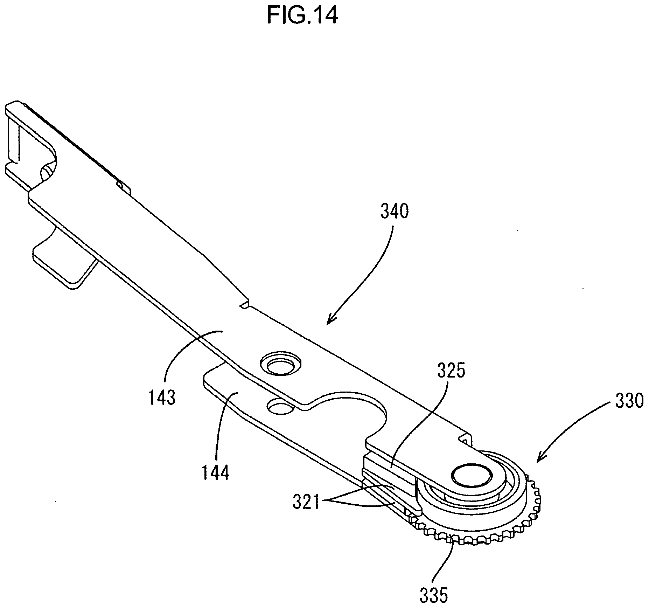

The present invention is not limited to the aspects explained in the above description made with reference to the drawings. The following aspects may be included in the technical scope of the present invention, for example.
(1) In the above embodiment, the first member 121, 151 has a shape having a tangent (a straight line) to the root circle C of the drawing teeth 115, 135. The first member 121, 151 may have any shape as long as it is in contact with the root circle C of the drawing teeth 115, 135. For example, as illustrated in FIG. 13, an outline L1 of the first member 121, 151 may be an arched shape that is in contact with the root circle C of the drawing teeth 115, 135.
   According to the configuration that the first member 121, 151 has the arched shape that is in contact with the root circle C, the top tape 75 separated from the drawing teeth 115, 135 is conveyed along the outline L1 of the first member 121, 151. Therefore, the conveyance of the tape is not interrupted in a rear area with respect to the roller and the top tape 75 is not retained in the rear area with respect to the roller. Thus, the entangling of the top tape 75 with each roller 110, 130 is less likely to occur.
(2) In the above embodiment, each of the tension roller 110 and the pinch roller 130 has a double teeth-member structure including two teeth-members having drawing teeth 115, 135. However, the number of the teeth-members is not necessarily two but may be one or three. If a pinch roller 330 of a lever 340 includes one teeth-member, as illustrated in FIG. 14, a first member 321 may be on both sides of a teeth-member including drawing teeth 335 of the pinch roller 330 and a second member 325 may be on both sides of the first member 321.

## Claims

1. A component supplying device (80) supplying an electronic component (W) with using a component supply minimum tape (70) having a small tape width, the component supplying device (80) comprising:
a feeding device (90) feeding the component supply minimum tape (70) toward a component pick-up position;
a drawing device (100) drawing a top tape (75) from the component supply minimum tape (70); and
a tape storing portion storing the top tape (75) drawn by the drawing device (100), wherein
the drawing device (100) includes:
a pair of rollers (110, 130) having drawing teeth (115A, 115B, 135A, 135B) on outer periphery thereof for drawing the top tape (75), and
first members (121, 151) arranged with respect to the respective rollers (110, 130) and for separating the top tape (75) from the drawing teeth (115A, 115B, 135A, 135B), each of the first members (121, 151) having a shape to be in contact with a root circle of the drawing teeth (115A, 115B, 135A, 135B);
**characterized by**
a second member (125A, 125B, 155A, 155B) that is at a forward position from the first member (121, 151) with respect to a rotating direction of the rollers (110, 130), the second member (125A, 125B, 155A, 155B) restricting the top tape (75) deviated from the first member (121, 151) from being entangled with the rollers (110, 130),
wherein
the pair of rollers (110, 130) has a double teeth structure and includes two teeth-members, and
the first member (121, 151) is fit in a groove portion (137) between the two teeth-members.

2. The component supplying device (80) according to claim 1, wherein the shape of the first member (121, 151) includes a tangent to the root circle of the drawing teeth (115A, 115B, 135A, 135B).

3. The component supplying device (80) according to claim 1 or 2, wherein
each of the second members (125A, 125B, 155A, 155B) has an outline (L2) that is inclined with respect to an outline (L1) of the first member (121, 151), and
a step is formed between the first member (121, 151) and each of the second members (125A, 125B, 155A, 155B).

4. A surface mounting device (1) comprising:
the component supplying device (80) according to any one of claims 1 to 3;
a head unit (60) including a mount head (63) that mounts an electronic component (W) supplied by the component supplying device (80) on a printed board; and
a driving device (30) that moves the head unit (60) in a horizontal direction.

## Patentansprüche

1. Komponentenzufuhrvorrichtung (80) zum Zuführen einer elektronischen Komponente (W) unter Verwendung eines minimalen Komponentenzufuhrbands (70) mit einer kleinen Bandbreite, wobei die Komponentenzufuhrvorrichtung (80) umfasst:
eine Vorschubvorrichtung (90), die das minimale Komponentenzufuhrband (70) in Richtung einer Komponentenaufnahmeposition speist;
eine Zugvorrichtung (100), die ein oberes Band (75) von dem minimalen Komponentenzufuhrband (70) zieht; und
einen Bandlagerabschnitt, der das obere Band (75), das von der Zugvorrichtung (100) gezogen wird, lagert, wobei
die Zugvorrichtung (100) umfasst:
ein Paar von Rollen (110, 130), die Zugzähne (115A, 115B, 135A, 135B) auf ihrem Außenumfang zum Ziehen des oberen Bands (75) haben, und
erste Elemente (121, 151), die in Bezug auf die jeweiligen Rollen (110, 130) und zum Trennen des oberen Bands (75) von den Zugzähnen (115A, 115B, 135A, 135B) eingerichtet sind, wobei jedes der ersten Elemente (121, 151) eine Form hat, um in Kontakt mit einem Fußkreis der Zugzähne (115A, 115B, 135A, 135B) zu sein;
**gekennzeichnet durch**
ein zweites Element (125A, 125B, 155A, 155B), das in Bezug auf eine Drehrichtung der Rollen (110, 130) an einer zu dem ersten Element vorderen Position ist, wobei das zweite Element (125A, 125B, 155A, 155B) das obere Band (75), das von dem ersten Element (121, 151) abgelenkt wird, dabei beschränkt, sich mit den Rollen (110, 130) zu verfangen,
wobei
das Paar von Rollen (110, 130) eine Doppelzahnstruktur hat und zwei Zahnelemente umfasst, und
das erste Element (121, 151) in einen Nutabschnitt (137) zwischen den zwei Zahnelementen eingepasst ist.

2. Komponentenzufuhrvorrichtung (80) nach Anspruch 1, wobei die Form des ersten Elements (121, 151) eine Tangente an den Fußkreis der Zugzähne (115A, 115B, 135A, 135B) umfasst.

3. Komponentenzufuhrvorrichtung (80) nach Anspruch 1 oder 2, wobei jedes der zweiten Elemente (125A, 125B, 155A, 155B) einen Umriss (L2) hat, der in Bezug auf einen Umriss (L1) des ersten Elements (121, 151) geneigt ist, und
eine Stufe zwischen dem ersten Element (121, 151) und jedem der zweiten Elemente (125A, 125B, 155A, 155B) ausgebildet ist.

4. Oberflächenmontagevorrichtung (1), die aufweist:
die Komponentenzufuhrvorrichtung (80) nach einem de Ansprüche 1 bis 3;
eine Kopfeinheit (60), die einen Montagekopf (63) umfasst, der eine elektronische Komponente (W), die von der Komponentenzufuhrvorrichtung (80) zugeführt wird, auf eine gedruckte Leiterplatte zuführt; und
eine Antriebsvorrichtung (30), welche die Kopfeinheit (60) in einer horizontalen Richtung bewegt.

## Revendications

1. Dispositif de distribution de composants (80) distribuant un composant électronique (W) au moyen d'une bande minimale de distribution de composants (70) avec une largeur de bande étroite, le dispositif de distribution de composants (80) comprenant :
un dispositif de transport (90) transportant la bande minimale de distribution de composants (70) vers une position de saisie de composants ;
un dispositif de traction (100) tirant une bande supérieure (75) de la bande minimale de distribution de composants (70) ; et
une partie de stockage de bande stockant la bande supérieure (75) tirée par le dispositif de traction (100), dans lequel
le dispositif de traction (100) comprend :
une paire de rouleaux (110, 130) ayant des dents de traction (115A, 115B, 135A, 135B) sur une périphérie extérieure de ceux-ci pour tirer la bande supérieure (75), et
des premiers éléments (121, 151) placés par rapport aux rouleaux respectifs (110, 130) et pour séparer la bande supérieure (75) des dents de traction (115A, 115B, 135A, 135B), chacun des premiers éléments (121, 151) ayant une forme pour être en contact avec un cercle racine des dents de traction (115A, 115B, 135A, 135B) ;
**caractérisé en ce que**
un second élément (125A, 125B, 155A, 155B) qui est à une position avant du premier élément (121, 151) par rapport à une direction de rotation des rouleaux (110, 130), le second élément (125A, 125B, 155A, 155B) empêchant la bande supérieure (75) déviée du premier élément (121, 151) de s'entremêler avec les rouleaux (110, 130),
dans lequel
la paire de rouleaux (110, 130) a une double structure de dents et comprend deux éléments à dents, et
le premier élément (121, 151) est ajusté dans une partie rainure (137) entre les deux éléments à dents.

2. Dispositif de distribution de composants (80) selon la revendication 1, dans lequel la forme du premier élément (121, 151) comprend une tangente au cercle racine des dents de traction (115A, 115B, 135A, 135B).

3. Dispositif de distribution de composants (80) selon la revendication 1 ou 2, dans lequel
chacun des seconds éléments (125A, 125B, 155A, 155B) a un profil (L2) qui est incliné par rapport à un profil (L1) du premier élément (121, 151), et
une marche est formée entre le premier élément (121, 151) et chacun des seconds éléments (125A, 125B, 155A, 155B).

4. Dispositif de montage en surface (1) comprenant :
le dispositif de distribution de composants (80) selon l'une quelconque des revendications 1 à 3 ;
une unité de tête (60) comprenant une tête de montage (63) qui monte un composant électronique (W) distribué par le dispositif de distribution de composants (80) sur un circuit imprimé ; et
un dispositif d'entraînement (30) qui déplace l'unité de tête (60) dans une direction horizontale.
